# EUROPEAN PATENT APPLICATION

(11) **EP 4 270 494 A1**
(43) Date of publication of application: **01.11.2023**
(21) Application number: 22857321.8
(22) Date of filing: 27.04.2022
(51) Int. Cl.: H01L 31/0236, H01L 31/18

(54) **SOLAR CELL, AND TEXTURED SURFACE STRUCTURE AND METHOD FOR PREPARING SAME**

(30) Priority: 17.08.2021 CN 202110943539
(71) Applicant: Tongwei Solar (Jintang) Co., Ltd., Chengdu City Sichuan 610400 (CN)
(72) Inventor: SUN, Lin, Chengdu, Sichuan 610299 (CN); DU, Junlin, Chengdu, Sichuan 610299 (CN); CHEN, Gongbing, Chengdu, Sichuan 610299 (CN); ZHANG, Lin, Chengdu, Sichuan 610299 (CN); YANG, Xiuqing, Chengdu, Sichuan 610299 (CN); LIU, Xiangfei, Chengdu, Sichuan 610299 (CN); YAN, Tao, Chengdu, Sichuan 610299 (CN); PAN, Deng, Chengdu, Sichuan 610299 (CN)
(74) Representative: Marks & Clerk LLP
(86) International application number: PCT/CN2022/089542
(87) International publication number: WO 2023/020003

(57) **Abstract**

A solar cell, a textured surface structure and a method for preparing the same are provided, belonging to the field of solar cells. The textured surface structure is formed on a surface of a silicon wafer, and the surface has a grid line covered area and a light-receiving exposure area. On this basis, the textured surface structure includes a first textured surface formed on the grid line covered area, and a second textured surface formed on the light-receiving exposure area, wherein the texture size of the first textured surface is larger than the texture size of the second textured surface. The electrical performance of a solar cell can be improved by using the textured surface structure.

## Description

### CROSS-REFERENCE TO RELATED APPLICATIONS

This application claims priority to Chinese patent application No. 2021109435390 filed with the China National Intellectual Property Administration on August 17, 2021, entitled "SOLAR CELL, AND TEXTURED SURFACE STRUCTURE AND METHOD FOR PREPARING SAME", the content of which is hereby incorporated by reference in its entirety. TECHNICAL FIELD

The present disclosure relates to the field of solar cells, and specifically to a solar cell, a textured surface structure and a method for preparing the same.

### BACKGROUND

As an energy conversion device, the conversion efficiency and conversion cost of solar cells are very important.

Currently, in all kinds of solar cells, the conversion efficiency of heterojunction solar cells based on monocrystal silicon is particularly prominent. During the process of manufacturing solar cells, it generally involves texturing monocrystal silicon. However, there are still some problems in the current texturing. Therefore, it is necessary to optimize the texturing quality to improve the performance of the solar cells.

### SUMMARY

A solar cell, a textured surface structure and a method for preparing the same are provided in the present disclosure, which can improve the short-circuit current and fill factor of solar cells.

The present disclosure is implemented as follows.

In some illustrative embodiments of the present disclosure, a textured surface structure formed on a surface of a silicon wafer is provided. The surface of the silicon wafer has a grid line covered area and a light-receiving exposure area.

The textured surface structure can include a first textured surface formed on the grid line covered area, and a second textured surface formed on the light-receiving exposure area. Moreover, the texture size of the first textured surface can be larger than the texture size of the second textured surface.

In some examples of the present disclosure, the texture size of the first textured surface can be 2 µm to 5 µm. The texture size of the second textured surface can be 1 µm to 2 µm.

In some examples of the present disclosure, the first textured surface and the second textured surface can each independently include a pyramidal textured surface, a pit textured surface, or a black silicon textured surface.

In some examples of the present disclosure, the first textured surface and the second textured surface can be tapered textured surfaces.

In some examples of the present disclosure, the surface includes a plurality of the grid line covered areas. The first textured surface corresponding to each grid line covered area can be the same textured surface. The surface includes a plurality of the light-receiving exposure areas. The second textured surface corresponding to each light-receiving exposure area can be the same textured surface.

In some illustrative embodiments of the present disclosure, a solar cell including the textured surface structure as described above is provided.

In some examples of the present disclosure, the number of the textured surface structure can be one, and the textured surface structure can be located on either a front surface or a back surface of the silicon wafer. Alternatively, the number of the textured surface structure can be two, and the two textured surface structures can be respectively located on the front surface and the back surface of the silicon wafer. Alternatively, the number of the textured surface structure can be two, and the two textured surface structures can be respectively located on the front surface and the back surface of the solar cell, wherein the type of the first textured surface of the textured surface structure on the front surface of the silicon wafer can be same as the type of the first textured surface of the textured surface structure on the back surface of the silicon wafer, and the type of the second textured surface of the textured surface structure on the front surface of the silicon wafer can be same as the type of the second textured surface of the textured surface structure on the back surface of the silicon wafer.

In some examples of the present disclosure, the solar cell can be a heterojunction solar cell. Alternatively, the solar cell can be a double-sided heterojunction solar cell. Alternatively, the solar cell can be a double-sided heterojunction solar cell, and the solar cell can include N-type monocrystal silicon, as well as intrinsic amorphous silicon, N⁺ doped amorphous silicon, a front transparent conductive oxide and a front electrode which are stacked sequentially on the front surface of the solar cell, and intrinsic amorphous silicon, P⁺ doped amorphous silicon, a back transparent conductive oxide and a back electrode which are stacked sequentially on the back surface of the solar cell.

In some illustrative embodiments of the present disclosure, a method for preparing a textured surface on a silicon wafer is provided.

The method includes:
providing a silicon wafer defining a grid line covered area and a light-receiving exposure area; and
respectively forming a textured surface with a large texture size on the grid line covered area and a textured surface with a small texture size on the light-receiving exposure area.

In some examples of the present disclosure, respectively forming a textured surface with a large texture size on the grid line covered area and a textured surface with a small texture size on the light-receiving exposure area includes:
making a patterned structure on the surface of the silicon wafer selected to be textured with a mask, wherein the patterned structure includes a hollow area corresponding to the grid line covered area of the silicon wafer, and a covered area corresponding to the light-receiving exposure area of the silicon wafer;
making a third textured surface on the surface of the silicon wafer corresponding to the hollow area, to form the textured surface with the large texture size; and
removing the covering on the covered area to form an exposed surface of the silicon wafer, and texturing the exposed surface to make a fourth textured surface on the exposed surface, to form the textured surface with the small texture size.

In some examples of the present disclosure, respectively forming a textured surface with a large texture size on the grid line covered area and a textured surface with a small texture size on the light-receiving exposure area can include:
making a patterned structure on the surface of the silicon wafer selected to be textured with a mask, wherein the patterned structure includes a hollow area corresponding to the grid line covered area of the silicon wafer, and a covered area corresponding to the light-receiving exposure area of the silicon wafer;
making a third textured surface on the surface of the silicon wafer corresponding to the hollow area; and
removing the covering on the covered area to form an exposed surface of the silicon wafer, and texturing the exposed surface to make a fourth textured surface on the exposed surface and extendedly texturing the third textured surface to form a fifth textured surface;
wherein the fourth textured surface can be the textured surface with the small texture size, and the fifth textured surface can be the textured surface with the large texture size.

In some examples of the present disclosure, the method includes one or more of the features of:
a. the texture size of the third textured surface is smaller or equal to the texture size of the fourth textured surface;
b. the patterned structure is a transparent conductive oxide; and
c. the texturing is performed by chemical etching.

In some examples of the present disclosure, the mask is a metal carrier plate and has a hollow area and a covered area. The hollow area and the covered area are spaced apart from each other.

In some examples of the present disclosure, wherein providing a silicon wafer can include pretreating the silicon wafer by polishing the surface of the silicon wafer with a chemical reagent.

In the above implementation, the textured surface structure provided in the embodiments of the present disclosure has a textured surface with a large texture size on the grid line covered area, and a textured surface with a small texture size on the non-grid line covered area (i.e., the light-receiving exposure area) by differentially texturing on the grid line covered area and the non-grid line covered area of the solar cell. As such, the selective distribution of the above textured surface structures can bring better electrical performance to the solar cell.

### BRIEF DESCRIPTION OF THE DRAWINGS

In order to illustrate the embodiments of the present disclosure more clearly, the drawings used in the embodiments will be described briefly. It should be understood that the following described drawings are merely for the embodiments of the present disclosure, and shall not be considered as limitation to the scope. Other drawings can be derived by those of ordinary skill in the art without any creative effort.
FIG. 1 is a scanning electron microscope image showing the contact condition between a textured surface structure with a small texture size and a grid line electrode paste in an example of the present disclosure.
FIG. 2 is a structural schematic diagram of a silicon heterojunction solar cell in an example of the present disclosure.
FIG. 3 is a schematic diagram showing the contact condition between a textured surface structure and a grid line in an example of the present disclosure.
FIG. 4 is a schematic diagram showing the contact condition between another textured surface structure and a grid line in an example of the present disclosure.
FIG. 5 is a schematic diagram showing the texture size of a pyramidal textured surface in an example of the present disclosure.
FIG. 6 is a structural schematic diagram of a black silicon textured surface in an example of the present disclosure.

Reference signs: 10, surface of silicon wafer; 111, large textured surface; 112, small textured surface; and 11, grid line paste particles.

### DETAILED DESCRIPTION

Texturing is an important process in the manufacturing process of solar cells. The textured surface formed by texturing can cause the light to be reflected, refracted, or the like for several times, and thus change the light transmission path and allow the light into the solar cell. The reflection of a solar cell surface to the light can be reduced and the absorption of the light can be increased by texturing, thereby improving the utilization rate of a solar cell to the light and the conversion efficiency of a solar cell.

Accordingly, texturing is generally positive for the performance of a solar cell.

However, the inventors have found that in practice, there are defects in the current texturing process and the formed structure, so that the performance of a solar cell may be deteriorated. Currently, it is generally considered to be caused by low quality in texturing. In a further study, the inventors have surprisingly found that this is mainly due to improper matching between the textured surface and the electrodes of a solar cell.

Specifically, the larger the textured surface of a silicon wafer, the greater the reflectivity of the solar cell to light. In contrast, the smaller the textured surface of a silicon wafer, the lower the reflectivity of the cell to light. The lower the reflectivity of a heterojunction solar cell, the higher the short-circuit current of the solar cell; so does other cells.

In other words, the electrical performance of a solar cell can be improved by texturing the textured surface of the solar cell to be a smaller texture size. Therefore, the current modification of the textured surface of the solar cell also focuses on improving the quality of the textured surface with the small texture size, mainly on reducing the texture size of the textured surface.

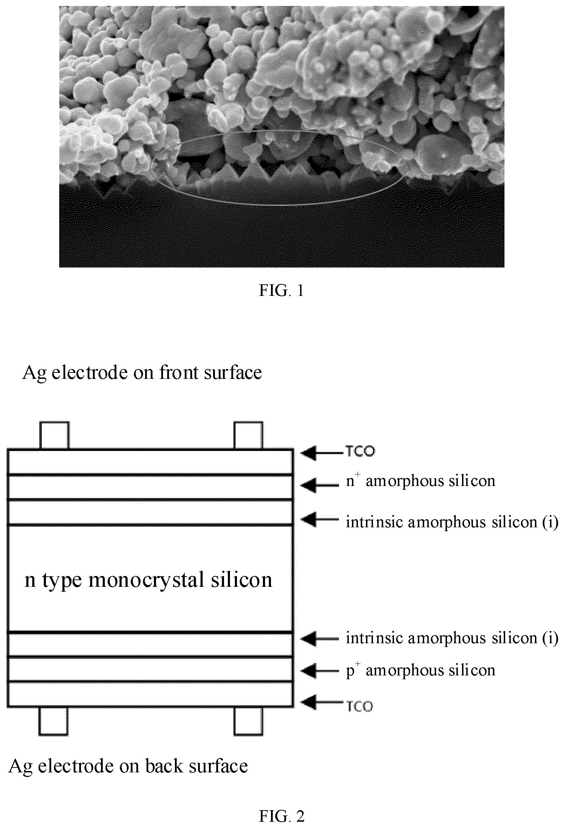

However, the inventors have found that a relatively small texture size of the textured surface is required for a low reflectivity, but a small texture size of the textured surface would adversely affect the performance of the grid line electrode for collecting current. Generally, a low-temperature paste with large particles is adopted as the grid line electrode, and some of the particles are larger than 5 µm, while the current texture size of a textured surface such as the pyramidal textured surface is about 2 µm. The low-temperature paste is adhered to the textured surface after being cured. The smaller the texture size of a textured surface, the worse the contact between the paste and the textured surface, which is partially adhered and partially uncontacted, as shown in FIG. 1.

The contact defect on the micro level between the textured surface and the paste has a negative effect on the performance of a solar cell by verification on the macro level. The inventors have analyzed that this is because the series resistance (Rs) is increased and thus the fill factor (FF) is decreased due to poor contact between the textured surface and the paste particles. Therefore, when the texture size of the textured surface is small, the current is increased, but the FF is decreased; and when the texture size of the textured surface is large, the current is decreased, but the FF is increased. That is, it is difficult to obtain a balance between the short-circuit current and the fill factor in the current texturing process, or it is difficult to simultaneously increase both of them at the same time.

In view of such understanding and finding, the inventors have proposed a new textured surface structure that can play a positive role in the above defects.

It should be noted that in illustrative examples of the present disclosure, a silicon heterojunction cell is taken as an example, but this is not intended to limit that the textured surface structure of the present disclosure can only be applicable to a silicon heterojunction cell. The textured surface structure of the present disclosure can also be applicable to other types of heterojunction cells and various types of solar cells, such as selective emitter cells, passivated emitter cells, back contact cells, etc.

A silicon heterojunction (SHJ) cell is also known as a heterojunction with intrinsic thin layer (HIT) cell. A silicon heterojunction cell is characterized by high conversion efficiency, high open circuit voltage (Voc), etc. The cell is typically based on a N-type silicon wafer as a substrate, and is generally manufactured in processes of texturing, depositing amorphous silicon, depositing a transparent conductive layer (TCO), screen printing, and testing. The structure is shown in FIG. 2. The cell is a double-sided heterojunction solar cell. The solar cell includes N-type monocrystal silicon, as well as intrinsic amorphous silicon, N+ doped amorphous silicon, a front transparent conductive oxide and a front electrode which are stacked sequentially on the front surface of the cell, and intrinsic amorphous silicon, P+ doped amorphous silicon, a back transparent conductive oxide and a back electrode which are stacked sequentially on the back surface of the cell.

Here, the texturing process mainly refers to performing on the N-type monocrystal silicon. Texturing can remove dirt and a damaged layer on the surface of the silicon wafer to form a textured surface. The textured surface can be a pit textured surface like rice grains, or a pyramidal textured surface, or other forms or types of textured surfaces.

The texturing process can be alkaline texturing process or acidic texturing process. In a heterojunction solar cell, a pyramid is generally formed on the surface of the N-type silicon wafer by performing the alkaline texturing process on the N-type silicon wafer. The pyramidal textured surface can have different sizes.

For example, the pyramidal textured surface can be classified as a small textured surface, a medium textured surface, and a large textured surface according to the texture size of the textured surface. Here, the pyramidal textured surface with a texture size of smaller than 2 µm can be considered to be a small textured surface, the pyramidal textured surface with a texture size between 2 µm to 5 µm can be considered to be a medium textured surface, and the pyramidal textured surface with a texture size of larger than 5 µm can be considered to be a large textured surface. The small textured surface has relatively low reflectivity, the medium textured surface has relatively high reflectivity, and the large textured surface has a higher reflectivity than that of the medium textured surface.

During the process of manufacturing a heterojunction solar cell, after texturing N-type silicon wafer, the thickness of each subsequent structural layer, such as intrinsic amorphous silicon, doped amorphous silicon, and a transparent conductive layer, is at nanoscale. For example, the amorphous silicon has a thickness of about 20 nm, and the TCO has a thickness of about 80 nm. Compared with these structures, the texture size of the textured surface of the textured surface structure is relatively small. Such a textured surface structure would determine the surface condition of the heterojunction solar cell and further determine the contact condition of the subsequent low temperature paste particles with the cell. The low temperature paste is mainly argentum paste for making a grid line electrode that can be busbar or finger, etc.

As far as the inventors know, a current low temperature paste can be used at a very low temperature, for example the maximum temperature cannot exceed 250°C. Therefore, when the above low temperature is used, the argentum paste could not be dissolved or melted, so that an alloy could not be formed. Hence, the contact condition and thus the conductive condition to a certain extent would depend on the particle size of the un-dissolvable low temperature paste and the surface morphology of the silicon wafer.

Currently, the pyramidal textured surface of a heterojunction has only one texture size on the same side of the cell. However, as described above, the inventors have found that in practice, the low temperature paste is adhered to the pyramidal textured surface after being cured, and the smaller the texture size of the pyramidal textured surface, the worse the contact of the paste with the pyramidal textured surface; when the pyramidal textured surface has only one texture size and the texture size is small, the Rs would be increased and the FF would be decreased, resulting in a lower FF. On the contrary, when the pyramidal textured surface has only one texture size and the texture size is large, the contact would be improved, but the reflectivity of the surface would be increased, resulting in a reduced current of the cell.

Briefly, when the texture size of a pyramidal textured surface is small, the current is increased, but the FF is decreased; and when the texture size of a pyramidal textured surface is relatively large, the current is decreased, but the FF is increased. The embodiments of the present disclosure can enable the current and the FF to be increased simultaneously, and thus achieve the purpose of improving the conversion efficiency of a solar cell.

In an embodiment, a cell is textured at the selected area. That is, texturing is performed in accordance with the requirements for functionalization of a textured surface, and thus different textured surfaces, mainly with different texture sizes, are obtained at different areas. For example, a textured surface with a small texture size is adopted for areas where less sunlight and low reflectivity are required; and a textured surface with a large texture size is adopted for areas where low series resistance is required.

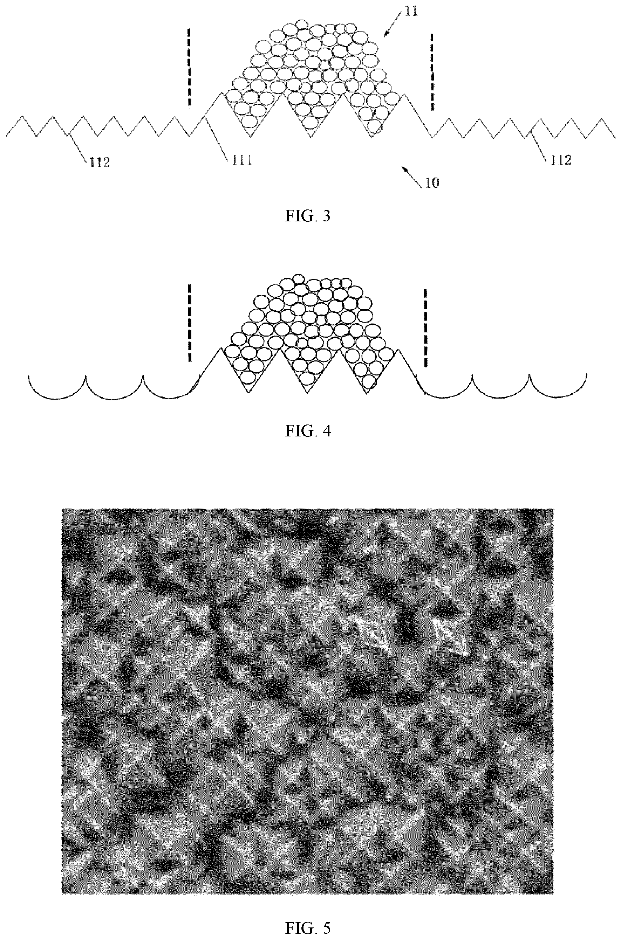

For example, the front surface of a cell, also known as the light incident surface or the light-receiving surface, has a light-receiving area and a non-light-receiving area (i.e., an area covered by the grid line electrode). Then, a textured surface with a small texture size can be formed for the light-receiving area, while a textured surface with a large texture size can be formed for the area covered by the grid line electrode. It will be appreciated that for a double-sided cell or a cell capable of generating electricity on the back surface, selective texturing can also be performed on the back surface in the manner as described above. In other words, in an illustrative embodiment of the present disclosure, two textured surfaces with different texture sizes, i.e., selective textured surfaces, can be formed on the same surface of a cell, either the front surface or the back surface. The textured surface with the large texture size can be used for contacting with the low temperature paste particles of the grid line electrode, and the textured surface with the small texture size can be used for receiving light. As an example, referring to FIGS. 3 and 4, there are a large textured surface 111 and a small textured surface 112 on the surface of a silicon wafer 10, and the grid line paste particles 11 are deposited on the large textured surface 111.

Therefore, a textured surface structure formed on the surface of a silicon wafer is provided in an embodiment of the present disclosure. The textured surface structure includes a first textured surface and a second textured surface. The texture size of the first textured surface is larger than the texture size of the second textured surface. For applying in a solar cell, the surface of the silicon wafer has a grid line covered area and a light-receiving exposure area. The first textured surface is formed on the grid line covered area, and the second textured surface is formed on the light-receiving exposure area.

The first textured surface and the second textured surface can be located either on one surface of the silicon wafer, or on two surfaces of the silicon wafer.

For example, in the case that the first textured surface and the second textured surface are located on the same surface of the silicon wafer, the first textured surface and the second textured surface both can be located on the front surface of the silicon wafer, or the first textured surface and the second textured surface both can be located on the back surface of the silicon wafer. In other words, the first textured surface and the second textured surface can both be located on the front surface of the silicon wafer or located on the back surface of the silicon wafer.

For example, in the case that the first textured surface and the second textured surface are located on the different surfaces of the silicon wafer, the first textured surface can be located on the front surface of the silicon wafer, and the second textured surface can be located on the back surface of the silicon wafer. Alternatively, the first textured surface can be located on the back surface of the silicon wafer, and the second textured surface can be located on the front surface of the silicon wafer.

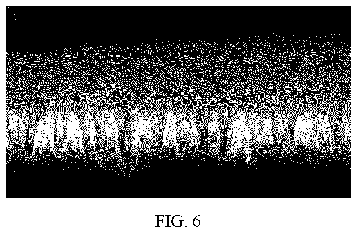

In addition to the texture size of the textured surface, the types of the first textured surface and the second textured surface can be same or different. That is, the first textured surface and the second textured surface can be of the same type, or can be of different types, which is not limited in the present disclosure. As an example, the first textured surface and the second textured surface each can independently be formed as a pyramidal textured surface, a pit textured surface, or a black silicon textured surface. The first textured surface and the second textured surface each can be formed as other types of the textured surface, such as tapered textured surfaces, etc. The structure of the pyramidal textured surface is shown in FIG. 5. The black silicon textured surface has micropores on the surface of the silicon wafer that are processed to have a size ranging from the micron level to the nanometer level, the structure of which is shown in FIG. 6.

It should be noted that, since the textured surface can be of different types, in the case that the above basic requirements are meet, i.e., a textured surface with a large texture size is adopted for the grid line covered area, and a textured surface with a small texture size is adopted for the light-receiving area, the types and sizes of the textured surfaces can be combined arbitrarily. As an illustrative selection of the texture size of the textured surface, the texture size of the first textured surface can be 2 µm to 5 µm, or 3 µm to 4 µm; and the texture size of the second textured surface can be 1 µm to 2 µm.

In order to make it easier for those skilled in the art to implement the embodiments of the present disclosure, a method for preparing a textured surface is also provided in some embodiments.

As an example, a method for preparing a textured surface on a silicon wafer, including:
providing a silicon wafer defining a grid line covered area and a light-receiving exposure area; and
respectively forming a textured surface with a large texture size on the grid line covered area, and a textured surface with a small texture size on the light-receiving exposure area.

Optionally, the method can include the steps as follows.

S101, a silicon wafer is provided.

A silicon wafer can be selected depending on the type of a cell. For example, for a silicon heterojunction solar cell, the silicon wafer can be N-type monocrystal silicon. For other types of cells, P-type silicon or amorphous silicon can be selected. In order to ensure that the quality of a silicon wafer and a subsequently manufactured cell, the silicon wafer can be pretreated to remove dirt, damage, etc. For example, the surface can be polished with a chemical reagent.

S 102, a patterned structure on the surface of the silicon wafer selected to be textured is made with a mask, wherein the patterned structure includes a hollow area corresponding to the grid line covered area of the silicon wafer, and a covered area corresponding to the light-receiving exposure area of the silicon wafer.

The mask can be used to distinguish different areas on the silicon wafer in order to make a patterned structure. The mask can be a flat-plate structure made of various suitable materials. Moreover, the flat-plate structure also has through holes distributed as required and arranged along the thickness direction. For example, the mask can be a metal carrier plate with a hollow area and a covered area. The hollow area and the covered area are spaced apart from each other. The hollow area can be through holes or rectangular apertures. The covered area can be a structure with entity.

As such, when the mask is adhered to or contacted with the surface of the silicon wafer to be textured, the hollow area and the covered area of the mask can classify the surface of the silicon wafer into an exposure area and a covered area.

Since the textured surface needs to be selectively formed on different areas, in order to ensure the precision of the textured surfaces on different areas, after the above mask is used, transparent conductive oxide (TCO) can be sputtered by using a method such as physical vapor deposition (PVD). In this way, a TCO film can be formed on the uncovered area (i.e., the exposure area) of the silicon wafer, while a TCO film cannot be formed on the covered area, thereby retaining the polished surface of the silicon wafer. As such, a TCO film with a patterned structure is formed on the polished surface of the silicon wafer.

S103, a third textured surface is formed on the surface of the silicon wafer corresponding to the hollow area of the patterned structure.

The exposed area of the TCO film with the patterned structure is textured to form the third textured surface. The silicon wafer and the TCO film can be placed together in a texturing tank for texturing. The texturing process can be implemented by chemical etching. For example, an alkaline liquid can be used for texturing. In another example, a laser can be used for texturing. However, the laser would cause damage to the silicon surface, and such damage can lead to a decrease in the conversion efficiency of a subsequently manufactured cell. Chemical etching can avoid the damage that would be caused in the texturing process by the laser.

S 104, the covering on the covered area of the patterned structure is removed to form an exposed surface of the silicon wafer, and the exposed surface of the silicon wafer is textured to form a fourth textured surface thereon. The texture size of the third textured surface is larger than the texture size of the fourth textured surface.

After the third textured surface is formed, a textured surface with another texture size can be formed by removing the covering on the covered area in the patterned structure. For example, a chemical reagent can be used for etching to remove the covering on the covered area. In some examples, the TCO film layer is etched off with hydrogen chloride or hydrochloric acid. Then, it is possible to perform texturing on the exposed surface of the silicon wafer which is formed by removing the covering on the covered area of the patterned structure. It shall be noted that, it is possible to selectively texture only the exposed surface of the silicon wafer formed by removing the covering on the covered area of the patterned structure, or to texture the entire surface of the silicon wafer to be textured.

Here, when only the exposed surface of the silicon wafer formed by removing the covering on the covered area of the patterned structure is selectively textured, chemical etching can be adopted for texturing. The texture size of the fourth textured surface (i.e., the textured surface in the exposed surface) is smaller than the texture size of the third textured surface formed in the step of S 103.

Here, when the entire surface of the silicon wafer to be textured is textured, the exposed surface of the silicon wafer formed by removing the covering on the covered area of the patterned structure are textured, and meanwhile, the area where the third textured surface is formed in the step of S 103 is also textured, so that a fifth textured surface is formed by extendedly texturing the third textured surface. That is, a third textured surface with one texture size is formed, and then a fourth textured surface with another texture size is formed. When the fourth textured surface is formed, a fifth textured surface can be simultaneously formed by extendedly texturing the third textured surface. In other words, texturing is performed twice on the surface area of the silicon wafer that would be subsequently covered by the grid lines, and texturing is performed once on the light-receiving area. In order to meet the requirements of the embodiments of the present disclosure, the texture size of the fourth textured surface is smaller than the texture size of the fifth textured surface. Meanwhile, the texture sizes of the third textured surface and the fourth textured surface can be relatively varied. For example, the texture size of the third textured surface can be less than or equal to the texture size of the fourth textured surface. Alternatively, the texture size of the third textured surface can be larger than the texture size of the fourth textured surface.

In the above embodiments, for the final product of a solar cell, a textured surface with a large texture size can be formed, followed by forming a textured surface with a small texture size.

In other embodiments, a textured surface with a small texture size can be formed, followed by forming a textured surface with a large texture size. For example, a patterned structure having a first TCO film (i.e., a patterned TCO film), is formed with a mask. In a hollow area of the patterned TCO film, a textured surface with a small texture size is first formed. Then the area having the textured surface with the small texture size is covered with a second TCO film, and the area having the first TCO film is subjected to removing the TCO film and texturing to form a textured surface with a large texture size. Then, the second TCO film is removed. Thus, a textured surface with a small texture size and a textured surface with a large texture size distributed on the surface of the silicon wafer are obtained according to different functionalization.

On the basis of the above embodiments, a solar cell having the textured surface structure as described above can be obtained. The number of the textured surface structure in the solar cell can be one, and the textured surface structure is located on either the front surface or the back surface of the silicon wafer. Alternatively, the number of the textured surface structure in the solar cell can be two, and the two textured surface structures are respectively located on the front surface and the back surface of the silicon wafer, such as in a double-sided silicon heterojunction solar cell having the textured surface structure as described in the embodiments of the present disclosure.

Alternatively, in other embodiments, the number of the textured surface structure in the solar cell can be two, and the two textured surface structures are respectively located on the front surface and the back surface of the solar cell. Moreover, the type of the first textured surface in the textured surface structure on the front surface of the cell or the silicon wafer is same as the type of the first textured surface in the textured surface structure on the back surface of the cell or the silicon wafer; and meanwhile, the type of the second textured surface in the textured surface structure on the front surface of the cell or the silicon wafer is the same as the type of the second textured surface in the textured surface structure on the back surface of the cell or the silicon wafer.

Alternatively, in some other embodiments, on the front surface of the silicon wafer, the grid lines can contact with the silicon wafer through the textured surface with the large texture size, while the other areas are of smooth surfaces. At the same time, on the back surface of the silicon wafer, the grid lines can contact with the silicon wafer through the smooth surface, while the other areas have textured surfaces with small texture sizes. As such, the silicon wafer has both a textured surface with a large texture size and a textured surface with a small texture size, which are respectively located on the front surface and back surface of the silicon wafer.

In an embodiment of the present disclosure, the texture size of a pyramidal textured surface refers to the average linear distance of the pyramidal diagonal per unit area, see FIG. 5. The texture size of a pit textured surface refers to the average diameter of the pit.

The present disclosure will be further described in detail below with reference to the examples.

### Example 1

A solar cell having a selective textured surface structure is manufactured as follows.

Step 1, a cleaning process. An N-type silicon wafer with a conventional M2 texture size and an area of 24432 mm² was adopted. The original silicon wafer was polished with a KOH solution to obtain a polished wafer, with the condition of a water volume ratio of 1:20, a temperature of 80°C, and a time of 120 seconds.

Step 2, the polished wafer was loaded on a carrier plate. Through the carrier plate, the grid line area was covered. The covered area is the same area for subsequently screenprinting the grid lines.

Step 3, TCO was sputtered by using PVD. The covered area was not sputtered with a TCO film.

Step 4, the polished wafer and the carrier plate were placed together in a texturing tank for first texturing, and a texturing additive for preparing a large textured surface was added to form a pyramidal textured surface with a texture size of 3 µm to 4 µm. Since the TCO is substantially not reacted with alkali, a large textured surface was formed on the area not sputtered with the TCO film during the first texturing. No reaction was occurred on the silicon substrate on the covered area.

Step 5, the silicon wafer subjected to first texturing was placed into a HCl tank to remove the TCO film layer with HCl.

Step 6, after the TCO film layer was removed, the silicon wafer was placed into another texturing tank for second texturing, and a texturing additive for preparing a small textured surface was added to form a pyramidal textured surface with a texture size of 1 µm to 2 µm. A uniform small textured surface was formed on the area where a textured surface was not formed by the first texturing. The area where the large textured surface was formed by first texturing was further extendedly textured. As a whole, a textured surface structure having the large textured surface formed on the grid line area and the small textured surface formed on the non-grid line area was formed.

Step 7, subsequent processes of depositing amorphous silicon, depositing TCO and screen printing were performed.

### Comparative Example 1

A solar cell having a conventional textured surface structure was manufactured using a method according to that of Example 1. Comparative Example 1 differs from Example 1 in the texturing process.

Step 1, a cleaning process. An N-type silicon wafer with a conventional M2 texture size and with an area of 24432 mm² was adopted. The original silicon wafer was polished with a KOH solution to obtain a polished wafer, with the condition of a water volume ratio of 1:20, a temperature of 80 °C, and time of 120 seconds.

Step 2, texturing was performed using texturing additives to form a textured surface with a large texture size on the surface of the polished wafer.

Step 3, subsequent processes of depositing amorphous silicon, depositing TCO and screen printing were performed.

The performances of heterojunction cells manufactured in Example 1 and Comparative Example 1 were tested. The results are shown in Table 1.

**Table 1**

| groups | quantity | Energy Conversion Efficiency (Eta) | Open circuit voltage (Uoc) | Short-circuit current (Isc) | Fill factor (FF) |
|---|---|---|---|---|---|
| Example 1 | 199 | 24.03 | 0.7451 | 9.371 | 84.1 |
| Comparative Example 1 | 198 | 23.92 | 0.7452 | 9.358 | 83.8 |

As can be seen from Table 1, after forming the selective textured surface according to the embodiments of the present disclosure, the short-circuit current (Isc) is significantly increased by 13 mA, the fill factor (FF) is increased by 0.3%, and the final conversion efficiency is increased by 0.11%.

The above-described embodiments are only several implementations of the present disclosure, and shall not be construed as limiting the scope of the present disclosure. For those of ordinary skill in the art, various modifications and changes can be made in the present disclosure. Without departing from the spirit and principle of the present disclosure, any modification, substitution, improvement, and the like can be made and all fall within the protection scope of the present disclosure.

### Industrial applicability

A solar cell, a textured surface structure and a method for preparing the same are provided in the present disclosure, belonging to the field of solar cells. The textured surface structure is formed on a surface of a silicon wafer having a grid line covered area and a light-receiving exposure area. On this basis, the textured surface structure includes a first textured surface formed on the grid line covered area, and a second textured surface formed on the light-receiving exposure area, wherein the texture size of the first textured surface is larger than the texture size of the second textured surface. The electrical performance of a solar cell can be improved by using the textured surface structure.

Furthermore, it will be appreciated that the textured surface structure, the solar cell, and the method for preparing a textured surface on a silicon wafer of the present disclosure can be reproducible and can be used in a variety of industrial applications. For example, the textured surface structure of the present disclosure can be applied to the field of solar cells.

## Claims

1. A textured surface structure, formed on a surface of a silicon wafer having a grid line covered area and a light-receiving exposure area, wherein the textured surface structure comprises:
a first textured surface formed on the grid line covered area, and
a second textured surface formed on the light-receiving exposure area,
wherein the texture size of the first textured surface is larger than the texture size of the second textured surface.

2. The textured surface structure according to claim 1, wherein the texture size of the first textured surface is 2 µm to 5 µm; and/or
the texture size of the second textured surface is 1 µm to 2 µm; and/or
the first textured surface and the second textured surface each independently comprise a pyramidal textured surface, a pit textured surface, or a black silicon textured surface.

3. The textured surface structure according to claim 1, wherein the first textured surface and the second textured surface are tapered textured surfaces.

4. The textured surface structure according to any one of claims 1 to 3, wherein the surface comprises a plurality of the grid line covered areas, and the first textured surface corresponding to each grid line covered area is the same textured surface; and/or
the surface comprises a plurality of the light-receiving exposure areas, and the second textured surface corresponding to each light-receiving exposure area is the same textured surface.

5. A solar cell comprising the textured surface structure according to any one of claims 1 to 4.

6. The solar cell according to claim 5, wherein the number of the textured surface structure is one, and the textured surface structure is located on either a front surface or a back surface of the silicon wafer; or
the number of the textured surface structure is two, and the two textured surface structures are respectively located on the front surface and the back surface of the silicon wafer; or
the number of the textured surface structure is two, and the two textured surface structures are respectively located on the front surface and the back surface of the silicon wafer, wherein the type of the first textured surface of the textured surface structure on the front surface of the silicon wafer is same as the type of the first textured surface of the textured surface structure on the back surface of the silicon wafer, and the type of the second textured surface of the textured surface structure on the front surface of the silicon wafer is same as the type of the second textured surface of the textured surface structure on the back surface of the silicon wafer.

7. The solar cell according to claim 5 or 6, wherein the solar cell is a heterojunction solar cell; or
the solar cell is a double-sided heterojunction solar cell; or
the solar cell is a double-sided heterojunction solar cell, and the solar cell comprises N-type monocrystal silicon, as well as intrinsic amorphous silicon, N⁺ doped amorphous silicon, a front transparent conductive oxide and a front electrode which are stacked sequentially on the front surface of the solar cell, and intrinsic amorphous silicon, P⁺ doped amorphous silicon, a back transparent conductive oxide and a back electrode which are stacked sequentially on the back surface of the solar cell.

8. A method for preparing a textured surface on a silicon wafer, comprising:
providing a silicon wafer defining a grid line covered area and a light-receiving exposure area; and
respectively forming a textured surface with a large texture size on the grid line covered area and a textured surface with a small texture size on the light-receiving exposure area.

9. The method according to claim 8, wherein respectively forming a textured surface with a large texture size on the grid line covered area and a textured surface with a small texture size on the light-receiving exposure area comprises:
making a patterned structure on a surface of the silicon wafer selected to be textured with a mask, wherein the patterned structure comprises a hollow area corresponding to the grid line covered area of the silicon wafer, and a covered area corresponding to the light-receiving exposure area of the silicon wafer;
making a third textured surface on the surface of the silicon wafer corresponding to the hollow area, to form the textured surface with the large texture size; and
removing a covering on the covered area to form an exposed surface of the silicon wafer, and texturing the exposed surface to make a fourth textured surface on the exposed surface, to form the textured surface with the small texture size.

10. The method according to claim 8, wherein respectively forming a textured surface with a large texture size on the grid line covered area and a textured surface with a small texture size on the light-receiving exposure area comprises:
making a patterned structure on a surface of the silicon wafer selected to be textured with a mask, wherein the patterned structure comprises a hollow area corresponding to the grid line covered area of the silicon wafer, and a covered area corresponding to the light-receiving exposure area of the silicon wafer;
making a third textured surface on the surface of the silicon wafer corresponding to the hollow area; and
removing a covering on the covered area to form an exposed surface of the silicon wafer, and texturing the exposed surface to make a fourth textured surface on the exposed surface and extendedly texturing the third textured surface to make a fifth textured surface;
wherein the fourth textured surface is the textured surface with the small texture size, and the fifth textured surface is the surface with the large size.

11. The method according to claim 10, wherein the method comprises one or more of the features of:
a. the texture size of the third textured surface is smaller or equal to the texture size of the fourth textured surface;
b. the patterned structure is a transparent conductive oxide; and
c. the texturing is performed by chemical etching.

12. The method according to claim 9 or 10, wherein the mask is a metal carrier plate and has a hollow area and a covered area, wherein the hollow area and the covered area are spaced apart from each other.

13. The method according to any one of claims 8 to 12, wherein providing a silicon wafer comprises pretreating the silicon wafer by polishing the surface of the silicon wafer with a chemical reagent.
